(19) Europäisches Patentamt
European Patent Office
Office européen des brevets

(11) **EP 4 390 417 A1**

(12) **EUROPÄISCHE PATENTANMELDUNG**

(43) Veröffentlichungstag:
**26.06.2024   Patentblatt 2024/26**

(21) Anmeldenummer: **23214480.8**

(22) Anmeldetag: **06.12.2023**

(51) Internationale Patentklassifikation (IPC):
**G01R 31/367** (2019.01)      **G01R 31/374** (2019.01)
**G01R 31/3835** (2019.01)

(52) Gemeinsame Patentklassifikation (CPC):
**G01R 31/388; G01R 31/367; G01R 31/3835;**
G01R 31/389

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(30) Priorität: **21.12.2022   DE 102022134261**

(71) Anmelder: **Lisa Dräxlmaier GmbH
84137 Vilsbiburg (DE)**

(72) Erfinder: **Lehmkuhl, Dirk
84036 Landshut (DE)**

(54) **ELEKTRONISCHE SCHALTUNG ZUR ERMITTLUNG DES LADEZUSTANDS EINER BATTERIEZELLE**

(57)    Die Erfindung betrifft eine elektronische Schaltung (100) zur Ermittlung eines Ladezustands (121), SOC, einer Batteriezelle eines Batteriesystems, wobei die elektronische Schaltung (100) ausgebildet ist, eine Mehrzahl von Messwerten (101) einer Ruhespannung der Batteriezelle mit zugehörigen Zeitwerten (102), zu denen die Messwerte (101) der Ruhespannung erfasst wurden, zu erhalten; eine Zeit (111), bis zu der ein zu einer Entladeschlussspannung der Batteriezelle zugehöriger Ladezustand, SOC (121) erreicht ist, basierend auf einer analytischen Lösung einer Funktion (110), welche einen Zusammenhang zwischen der Ruhespannung und dem Ladezustand (111) der Batteriezelle angibt, zu bestimmen; und den Ladezustand, SOC (121) der Batteriezelle basierend auf einer Umkehrfunktion (120) der ladezustandsabhängigen Zeit (111) zu ermitteln.

Fig. 1

Processed by Luminess, 75001 PARIS (FR)

**Beschreibung**

**Technisches Gebiet**

Die vorliegende Erfindung betrifft eine elektronische Schaltung zur Ermittlung eines Ladezustands einer Batteriezelle eines Batteriesystems basierend auf einer analytischen Lösung und ein entsprechendes Verfahren. Das Batteriesystem kann beispielsweise in elektrischen Fahrzeugen eingesetzt werden. Insbesondere betrifft die Erfindung die alterungsabhängige Online-Entladungserkennung von Batteriezellen wie beispielsweise Lithium-Ionen Zellen basierend auf einem elektrochemischen Modell und erweiterten Kalman-Filter mittels einer rechen- und speichersparsamen Lösungsmethode.

**Stand der Technik**

Das BMS (Batterie Management System) und die darauf befindliche Software werden zum Beispiel benötigt, den aktuellen Ladezustand der Batterie (State of Charge, SOC) zu berechnen und eine Leistungsprädiktion (State of Power, SOP) durchzuführen. Hierbei ist die Genauigkeit der SOC und SOP - Funktion von besonderer Bedeutung. Sie ermöglicht zum Beispiel den optimalen und sicheren Betrieb der Batterie bis zur erneuten Batterieladung durch eine genaue Reichweitenbestimmung und verhindert zum Beispiel ein Liegenbleiben des Fahrzeuges. Ungenauigkeiten bei der Spannungs- und Strommessung und Toleranzen in den Kapazitäten der einzelnen Zellen der Batterie führen zu einer immer ungenaueren SOC und SOP - Bestimmung. Darüber hinaus nimmt die Kapazität der Batterie aufgrund der Alterung (State of Health, SOH) stetig ab, so dass beim Entladen die minimale Spannung bei gleichem Strom in immer kürzeren Zeiten erreicht wird. Dies lässt sich entsprechend durch Zellauswahl und genauere Messchips kostenintensiv nur bedingt optimieren. Der Hersteller (OEM) fordert in seinem Lastenheft in der Regel eine SOC Genauigkeit von 2 - 4% bis zum Lebensende (End of Life, EOL). Aus diesem Grund muss der SOC immer wieder mit geeigneten Verfahren korrigiert (rekalibriert) werden. Häufig sind Software - Verfahren, die eine sehr genaue SOC - Korrektur ermöglichen, sehr rechen- und speicherintensiv und durch den verfügbaren Speicher (RAM) und die Leistung der CPU des Mikrocontrollers begrenzt.

Bisher gibt es zu einem auch im Folgenden verwendeten Standardmodell - dem elektrochemischen Modell (EM) - nur rechen- und speicherintensive und damit teure Umsetzungen, zum Beispiel auf einem leistungsfähigen Mikrocontroller. Hierbei wird die SOC Korrektur über den gesamten Zustandsbereich mittels eines erweiterten Kalman - Filters durchgeführt. Die in der Regel zum Einsatz kommenden Messchips sind hinsichtlich der Strommessung so genau, dass über den gesamte Zustandsbereich eine SOC-Korrektur für die Erreichung der oben genannten Genauigkeit gar nicht erforderlich ist. Für die SOP Funktion werden 2, 10, 30 Sekunden Grenzströme kennfeldbasiert prädiziert. Nur im unteren SOC - Bereich werden Grenzströme so begrenzt, dass die untere Entladeschlussspannung nicht unterschritten wird. Aus Sicht des OEMs ist aufgrund der Kosten für den zum Beispiel oben genannten Mikrocontroller (MCU), die bisherige Lösung hinsichtlich des Kosten-Nutzen-Verhältnisses nicht wirtschaftlich und damit kaum serientauglich. Aus diesen genannten Gründen ist ein genaues Modell für einen Teil-Zustandsbereich sinnvoll.

Bei den bekannten Verfahren werden bei der Batteriezustandserkennung für die SOC-Berechnung in Zusammenhang mit dem Kalman-Filter hauptsächlich Ersatzschaltbild Modelle (ECM - Modelle) mit ein oder zwei RC Gliedern eingesetzt. Um die alterungsabhängigen ECM-Parameter zu berücksichtigen, werden darüber hinaus echtzeitfähige Parameterschätzer verwendet. Serientaugliche Verfahren, die auf elektrochemischen Modellen (EMs) beruhen, sind derzeit nicht verfügbar. Auch Online-Parameterschätzer sind momentan nicht verfügbar. Bekannt sind lediglich sogenannte digitale Zwillinge (TWAICE), bei denen die Auswertung des Batteriezustandes in einer Cloud auf einem externen Rechner erfolgt. Hier können auch Alterungseffekte von Modellparametern berücksichtigt werden.

Bei der SOP - Funktion kommen derzeit nur ECM - Modelle zum Einsatz. Dabei wird eine spezielle Lösung der Differentialgleichung eines ECM-Modells verwendet, um den maximalen Strom bis zu einer unteren Entladeschlussspannung zu bestimmen.

**Beschreibung der Erfindung**

Eine Aufgabe der Erfindung ist es daher, ein Konzept für eine verbesserte Ladezustandsbestimmung der Batteriezellen eines Batteriesystems, beispielsweise für ein elektrisches Fahrzeug, zu schaffen.

Insbesondere ist es eine Aufgabe der Erfindung, eine Ladezustandsbestimmung zu schaffen, bei welcher der Ladezustand mit hoher Genauigkeit bei geringem Hardwareaufwand ermittelt werden kann.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Die Erfindung basiert auf der Idee, mittels einer neuen speziellen Funktion eine geschlossene, analytische Lösung des physikalischen Modells aufzuzeigen, die speziell in Entladerichtung bei niedrigeren SOC Werten in Kombination mit dem genauen Standardmodell Anwendung findet, so dass das optimale Ergebnis zwischen benötigter SOC und SOP - Genauigkeit und Hardware-Anforderungen gefunden werden kann.

Eine Lösung in geschlossener Form (oder ein Ausdruck in geschlossener Form) ist eine beliebige Formel, die in einer endlichen Anzahl von Standardoperationen ausgewertet werden kann. Eine numerische Lösung ist jede Näherung, die in einer endlichen Anzahl von Standardoperationen ausgewertet werden kann. Lösungen in geschlossener Form und numerische Lösungen sind insofern ähnlich, als beide mit einer endlichen Anzahl von Standardoperationen bewertet werden können. Sie unterscheiden sich darin, dass eine geschlossene Lösung genau ist, während eine numerische Lösung nur eine ungefähre ist.

Die analytische Lösung ermöglicht für die SOP - Funktion, eine sehr genaue Prädiktion der Grenzströme über die üblichen Pulszeiten von 30 Sekunden hinaus. Es steht erstmals für die SOC - Berechnung ein Kalman - Filter für dieses physikalische Modell zur Verfügung, welcher unabhängig von der Schrittweite die Werte exakt berechnen kann.

Elektrochemische Modelle (EMs) und Ersatzschaltbild Modelle (ECMs) bilden die modellbasierten Methoden zum Einrichten eines Kalman-Filters und dessen Verwendung für SOC-Berechnungen. ECMs erfordern wenig Rechenleistung von Mikrocontroller Units (MCUs) und sind aufgrund ihres geringen Parametrierungsaufwands in Echtzeitanwendungen von Batteriezustandsalgorithmen weit verbreitet. ECM Modelle haben jedoch normalerweise eine begrenzte physikalische Bedeutung und ihre Gültigkeit ist auf den Bereich ihrer anfänglichen Parametrisierung beschränkt. Darüber hinaus können herkömmliche ECMs innere physikalische Prozesse nicht beschreiben. Das Doyle-Fuller-Newman (DFN)-Modell ist ein weit verbreitetes elektrochemisches Modell. Theoretisch ermöglicht das Modell eine sehr genaue Beschreibung von Zellverhalten. Nachteil ist aber vergleichsweise ein komplexer Parameteridentifikationsprozess. In einigen Publikationen wird ausgehend von dem DFN-Modell voller Ordnung ein reduziertes Modell abgeleitet, welches insbesondere für Lithium-Eisenphosphat-Zellen nur geringe zusätzliche Ungenauigkeiten aufweist.

EM und ECM - Modelle werden bei der SOC - Bestimmung über einen Zustandsbeobachter für den gesamten Betriebsbereich verwendet. Bei der SOP Funktion hingegen werden nur ECM-Modelle in einem unteren SOC-Bereich verwendet. Das ECM-Modell hat nur eine begrenzte Gültigkeit bzw. höhere Ungenauigkeit, insbesondere bei niedrigen Ladezuständen und höheren Strömen. Das Problem wird jetzt dadurch technisch gelöst, indem ein reduziertes EM - Modell nur für den unteren SOC-Bereich eingesetzt wird. Dies verbessert die Genauigkeit bei den niedrigeren Ladezuständen und höheren Strömen wesentlich. Darüber hinaus kann selbst bei Zuständen, die weiter von der Entladeschlussspannung entfernt sind der maximale Grenzstrom genau bestimmt werden. Hier greifen in der Regel von dem Hersteller freigegebene tabellierte Werte. Mit der Erfindung kann hier ein stromunabhängiger Innenwiderstand der Batterie bestimmt werden, der auch für die leistungsbezogene Alterung herangezogen werden kann. Der große Fortschritt ist, dass für das reduzierte EM, mit nur unwesentlichen Vereinfachungen, erstmalig eine analytische Lösung abgeleitet werden kann. Die Lösung ist immer exakt und unabhängig von der Schrittweite $\Delta h$, die in den bisherigen Lösungen nötig war. Das reduzierte EM hat wesentlich weniger Parameter als bei den üblichen Lösungen. Für die SOC-Bestimmung erlaubt die Erfindung eine weniger speicherund rechenintensive Lösung und auch einen Parameterschätzer, der die alterungsabhängigen Parameter mittels der analytischen Fitfunktion mit einer nichtlinearen Regression auch in Echtzeit Online bestimmen kann.

Mit dieser Erfindung wird erstmalig eine Lösung für eine Verbesserung eines Standardzellmodells (elektrochemisches Modell) präsentiert, welche eine Erweiterung des Gültigkeitsbereiches bzw. der Genauigkeit liefert. Erstmalig konnte dieses Modell gelöst werden und eine geschlossene und analytische Lösung angegeben werden.

Dies war bisher nur für ECM-Modelle mit ein oder 2 RC Gliedern möglich. Die Komplexität des Kalman-Filters und damit die Anforderung an die Hardware, auf der die Applikation läuft, ist gegenüber der bisherigen Lösung, wie oben beschrieben, wesentlich reduziert. Daher ist hier ein Online-Parameterschätzer erstmalig möglich und sinnvoll. Der Zeithorizont der Leistungsprädiktion (SOP) ist gegenüber der Standardlösung größer, d.h. bei gleicher Genauigkeit kann die verfügbare Leistung der Batterie länger vorhergesagt werden.

Es ist sogar eine Prädiktion realisierbar, wo die bekannte Lösung (ECM - Modelle) mit tabellarischen Werten arbeitet, die vom Zellhersteller freigegen worden sind. Dadurch wird die Berechnung eines stromunabhängigen Innenwiderstandes realisierbar. Die hier vorgestellte Methode liefert darüber hinaus noch andere Informationen wie zum Beispiel die Zeit zu einem festen Ladezustand und Entladeschlussspannung, die für die Leistungsbewertung nützlich ist. Dadurch ergibt sich ein technischer Vorteil gegenüber der Nutzung der bekannten Lösung. Die hier vorgestellte Methode ist technologieunabhängig.

Insbesondere für Technologien, wie LiFePO4, bei denen die sogenannte OCV- Methode nur unbefriedigende Ergebnisse bei der SOC Rekalibrierung liefert, ist das hier dargestellte Verfahren eine ideale Alternative. Dabei können hohe HW-Kosten für eine entsprechend genaue Spannungsmessung eingespart werden.

Es wird ein erweiterter Kalman-Filter vorgestellt, der einen genaueren SOC liefert oder gleichbedeutend weniger zeit- und rechenintensiv ist. Dies kann bei der Wahl des Mikrocontrollers (Hardware) einen Kostenvorteil bedeuten. Nach dem Stand der Technik existieren genau aus diesem Grund zahlreiche, alternative Algorithmen zum Kalman-Filter, die jedoch andere Techniken verwenden. Es ergeben sich damit eine Vielzahl von Einsatzmöglichkeiten, der hier dargestellten Methode.

Zusammenfassend lässt sich feststellen: Der Vorteil besteht darin, dass mit der Erfindung der verfügbare Speicher (RAM) und die Leistung der CPU verbessert werden kann, d.h. zusätzliche und komplexere Algorithmen auf der BMU (Battery Management Unit) können bei gleicher Hardware umgesetzt werden. Bei gleichbleibender Funktion eines Batteriekerns (BatteryCore) kann ein günstigerer Chip eingesetzt werden.

Gemäß einem ersten Aspekt der Erfindung wird die Aufgabe gelöst durch eine elektronische Schaltung zur Ermittlung eines Ladezustands, SOC, einer Batteriezelle eines Batteriesystems, wobei die elektronische Schaltung ausgebildet ist, eine Mehrzahl von Messwerten einer Ruhespannung der Batteriezelle mit zugehörigen Zeitwerten, zu denen die Messwerte der Ruhespannung erfasst wurden, zu erhalten; eine Zeit, bis zu der ein zu einer Entladeschlussspannung der Batteriezelle zugehöriger Ladezustand erreicht ist, basierend auf einer analytischen Lösung einer Funktion, welche einen Zusammenhang zwischen der Ruhespannung und dem Ladezustand der Batteriezelle angibt, zu bestimmen; und den Ladezustand der Batteriezelle basierend auf einer Umkehrfunktion der ladezustandsabhängigen Zeit zu ermitteln.

Eine solche elektronische Schaltung sorgt für eine verbesserte Ladezustandsbestimmung der Batteriezellen eines Batteriesystems, beispielsweise eines elektrischen Fahrzeugs. Bei der elektronischen Schaltung ist eine SOC-Bestimmung mit höherer Genauigkeit unter Berücksichtigung der Alterung mit einfachen rechensparsamen Methoden möglich. Wie bereits oben erwähnt, kann mit der Realisierung einer solchen elektronischen Schaltung der verfügbare Speicher (RAM) und die Leistung der CPU verbessert werden. Es können damit zusätzliche und komplexere Algorithmen auf der BMU bei gleicher Hardware umgesetzt werden. Bei gleichbleibender Funktionalität kann ein günstigerer Chip eingesetzt werden.

Gemäß einer beispielhaften Ausführungsform der elektronischen Schaltung basiert die Funktion auf einem elektrochemischen Modell der Batteriezelle.

Mit dem elektrochemischen Modell der Batteriezelle kann eine wesentlich genauere Bestimmung der charakteristischen Größen der Batteriezelle, insbesondere des Ladezustands, durchgeführt werden als mit einem Ersatzschaltbild der Batteriezelle.

Gemäß einer beispielhaften Ausführungsform der elektronischen Schaltung ist das elektrochemische Modell der Batteriezelle für einen unteren Bereich des Ladezustands aufgestellt.

Damit wird der technische Vorteil erreicht, dass sich das Modell vereinfacht, wenn nur der untere Bereich des Ladezustands beachtet werden muss, d.h., es werden weniger Parameter benötigt und die Rechenkomplexität reduziert sich mit der Nutzung solch eines reduzierten Modells. Außerdem hat sich gezeigt, dass für die Ladezustandsbestimmung die Auswertung des unteren Bereichs des Ladezustands ausreichend ist, ohne dass die Genauigkeit leidet.

Gemäß einer beispielhaften Ausführungsform der elektronischen Schaltung umfasst der untere Bereich des Ladezustands Ladezustände kleiner als 50 Prozent.

Es hat sich herausgestellt, dass für eine Auswertung mit dem reduzierten Modell eine Betrachtung von Ladezuständen kleiner als 50% für die Ladezustandsbestimmung ausreichend ist.

Gemäß einer beispielhaften Ausführungsform der elektronischen Schaltung beruht das elektrochemische Modell der Batteriezelle auf einer Butler-Volmer Gleichung, welche eine Beziehung einer Stromdichte der Batteriezelle in Bezug zu einer Potentialdifferenz zu einem Gleichgewichtspotential der Batteriezelle angibt.

Die Butler-Volmer-Gleichung beschreibt in der Elektrochemie die Reaktionskinetik in der Nähe des Gleichgewichtspotentials $E_{eq}$. Die Stromdichte j, welche in der Elektrochemie einer Reaktionsrate entspricht, wird durch die Butler-Volmer-Gleichung in Bezug zur Potentialdifferenz $E-E_{eq}$ gesetzt. Diese Potentialdifferenz zum Gleichgewichtspotential wird auch als Durchtrittsüberspannung η bezeichnet. Diese Gleichung bildet die Grundlage der elektrochemischen Reaktionskinetik im Gleichgewicht zwischen Oxidations- und Reduktionsreaktionen.

Damit wird der technische Vorteil erreicht, dass mittels der Butler-Volmer Gleichung der Ladezustand der Batteriezelle sehr genau bestimmt werden kann.

Gemäß einer beispielhaften Ausführungsform der elektronischen Schaltung spezifiziert die Funktion den Ladezustand abhängig von der Ruhespannung und einer Temperatur der Batteriezelle.

Damit wird der technische Vorteil erreicht, dass eine temperaturabhängige Auswertung sehr genau ist, insbesondere für einen großen Temperaturbereich, in dem die Batteriezelle arbeitet.

Gemäß einer beispielhaften Ausführungsform der elektronischen Schaltung basiert die Funktion auf einer Logarithmus-Funktion, die abhängig ist von dem Ladezustand und der Temperatur.

Es hat sich gezeigt, dass über den Ansatz mit einer logarithmischen Funktion sich die Ruhespannungskennlinie der Batteriezelle hinreichend genau beschreiben lässt.

Gemäß einer beispielhaften Ausführungsform der elektronischen Schaltung bestimmt sich die Funktion wie folgt:

$$U_{OCV}(T, SOC) = K_0(T) + log\left(\left((SOC)(1-SOC)\right)^{K_1(T)}\right)$$

wobei Uocv (T, SOC) einen zeitlichen Verlauf der Ruhespannung der Batteriezelle darstellt, welche abhängig ist von der Temperatur T und dem Ladezustand SOC und wobei $K_0(T)$ und $K_1(T)$ temperaturabhängige Parameter der Batteriezelle darstellen.

Es hat sich gezeigt, dass sich mit diesem Ansatz im unteren SOC-Bereich die Ruhespannungskennlinie bei Lithium-Ionen-Zellen mit verschiedenen Kathodenmaterialien hinreichend genau beschreiben lässt.

Gemäß einer beispielhaften Ausführungsform der elektronischen Schaltung basiert die analytische Lösung der Funktion auf einer Ableitung der Zeit nach dem Ladezustand.

Es hat sich gezeigt, dass eine Ableitung der Zeit nach dem Ladezustand eine einfachere Lösung ergibt als eine Ableitung des Ladezustands nach der Zeit.

Gemäß einer beispielhaften Ausführungsform der elektronischen Schaltung bestimmt sich die Ableitung der Zeit nach dem Ladezustand wie folgt:

$$\frac{dt(SOC)}{dSOC} = \frac{(SOC)^{-\beta}(1 - SOC)^{-\beta}}{j_{00}\, c_e^{\beta}\, \sinh\!\left[v\left(U_N - U_{OCV}(K_0, K_1, SOC, T)\right)\right]}$$

wobei t die Zeit darstellt, T die Temperatur, SOC den Ladezustand, Uocv die Ruhespannung, $K_0(T)$ und $K_1(T)$ temperaturabhängige Parameter der Batteriezelle, $c_e$ eine Elektrolytkonzentration der Batteriezelle, $j_{00}$ eine Austauschstromdichte bei Standardtemperatur von 25°C und $\beta$ einen Parameter der Batteriezelle darstellen.

Es hat sich gezeigt, dass eine solche Gleichung eine geschlossene, analytische Lösung hat, so dass sich die Zeit, zu der ein bestimmter Ladezustand erreicht ist, sehr genau bestimmen lässt.

Gemäß einer beispielhaften Ausführungsform der elektronischen Schaltung ist die elektronische Schaltung ausgebildet, die Umkehrfunktion der ladezustandsabhängigen Zeit basierend auf einem Newton-Verfahren zu bestimmen.

Dies bietet den technischen Vorteil, dass mittels des Newton-Verfahrens sich die Umkehrfunktion auf einfache Weise hinreichend genau numerisch bestimmen lässt und damit den Ladezustand der Batterie mit hoher Genauigkeit liefert.

Gemäß einer beispielhaften Ausführungsform der elektronischen Schaltung ist die elektronische Schaltung ausgebildet, einen Leistungszustand, SOP, der Batteriezelle basierend auf Basis der ermittelten Zeit, bis zu der ein zu einer Entladeschlussspannung der Batteriezelle zugehöriger Ladezustand erreicht ist, zu bestimmen.

Dies bietet den technischen Vorteil, dass sich nach Bestimmung des Ladezustands der Batteriezelle sich ein zugehöriger Leistungszustand der Batteriezelle auf einfache Weise bestimmen lässt.

Der Leistungszustand (State-of-Power, SOP) einer Batteriezelle ist definiert als das Verhältnis von Spitzenleistung zu Nennleistung. Die Spitzenleistung, basierend auf den aktuellen Bedingungen der Batteriezelle, ist die maximale Leistung, die für eine vorgegebene Zeit konstant gehalten werden kann, ohne die vorgegebenen Auslegungsgrenzen für Batteriespannung, SOC, Leistung und Strom zu verletzen.

Gemäß einer beispielhaften Ausführungsform der elektronischen Schaltung ist die elektronische Schaltung ausgebildet, einen stromunabhängigen Innenwiderstand der Batteriezelle auf Basis des ermittelten Ladezustands zu bestimmen.

Dies bietet den technischen Vorteil, dass der Innenwiderstand der Batteriezelle stromunabhängig bestimmt werden kann, somit also für einen großen Bereich unterschiedlicher Ströme genau angegeben werden kann.

Gemäß einer beispielhaften Ausführungsform der elektronischen Schaltung ist die elektronische Schaltung ausgebildet, auf Basis der analytischen Lösung einer Funktion einen Zustandsbeobachter mit Kalman-Filter zu erzeugen und ein oder mehrere Zustände der Batteriezelle zu beobachten.

Dies bietet den technischen Vorteil, dass über den Zustandsbeobachter mit Kalman-Filter eine dynamische Ermittlung des Ladezustands und entsprechender Zustandsgrößen der Batteriezelle hinreichend genau erfolgen kann.

Gemäß einer beispielhaften Ausführungsform der elektronischen Schaltung ist die elektronische Schaltung ausgebildet, auf Basis der analytischen Lösung der Funktion ein oder mehrere Parameter eines Ersatzschaltbildmodells der Batteriezelle zu bestimmen.

Dies bietet den technischen Vorteil, dass über die hier vorgestellte analytische Lösung der Funktion sich auch die Parameter eines Ersatzschaltbildmodells der Batteriezelle sehr genau bestimmen lassen, so dass die hier vorgestellte Lösung auch für Ersatzschaltbildmodelle eingesetzt werden kann.

Gemäß einem zweiten Aspekt der Erfindung wird die Aufgabe gelöst durch ein Batteriemanagementsystem mit: einem Controller zur Erfassung einer Mehrzahl von Messwerten einer Ruhespannung einer Batteriezelle eines Batteriesystems mit zugehörigen Zeitwerten, zu denen die Messwerte der Ruhespannung erfasst wurden; und einer elektronischen Schaltung gemäß dem ersten Aspekt zur Bestimmung des Ladezustands der Batteriezelle.

Wie bei der elektronischen Schaltung gemäß dem ersten Aspekt ergibt sich auch hier der Vorteil einer verbesserten Ladezustandsbestimmung der Batteriezellen eines Batteriesystems, beispielsweise eines elektrischen Fahrzeugs. Bei einem solchen Batteriemanagementsystem ist eine SOC-Bestimmung mit höherer Genauigkeit unter Berücksichtigung der Alterung mit einfachen rechensparsamen Methoden möglich.

Gemäß einem dritten Aspekt der Erfindung wird die Aufgabe gelöst durch ein Verfahren zur Ermittlung eines Ladezustands, SOC, einer Batteriezelle eines Batteriesystems, wobei das Verfahren die folgenden Schritte aufweist: Erhalten einer Mehrzahl von Messwerten einer Ruhespannung der Batteriezelle mit zugehörigen Zeitwerten, zu denen die Messwerte der Ruhespannung erfasst wurden; Bestimmen einer Zeit, bis zu der ein zu einer vorgegebenen Entladeschlussspannung der Batteriezelle zugehöriger Ladezustand erreicht ist, basierend auf einer analytischen Lösung einer Funktion, welche einen Zusammenhang zwischen der Ruhespannung und dem Ladezustand der Batteriezelle angibt; und Ermitteln des Ladezustands der Batteriezelle basierend auf einer Umkehrfunktion der ladezustandsabhängigen Zeit.

Wie bei der elektronischen Schaltung gemäß dem ersten Aspekt ergibt sich auch bei dem Verfahren gemäß dem dritten Aspekt der Vorteil einer verbesserten Ladezustandsbestimmung der Batteriezellen eines Batteriesystems, beispielsweise eines elektrischen Fahrzeugs. Bei einem solchen Verfahren ist eine SOC-Bestimmung mit höherer Genauigkeit unter Berücksichtigung der Alterung mit einfachen rechensparsamen Methoden möglich.

Gemäß einem vierten Aspekt der Erfindung wird die Aufgabe gelöst durch ein Computerprogramm mit einem Programmcode zum Ausführen des Verfahrens gemäß dem dritten Aspekt auf einer elektronischen Schaltung gemäß dem ersten Aspekt oder einem Batteriemanagementsystem gemäß dem zweiten Aspekt.

Damit wird der technische Vorteil erreicht, dass das Computerprogramm einfach auf einem Fahrzeugsteuergerät ausgeführt werden kann, welches die Echtzeitanforderung stückkostenneutral umsetzen kann, ohne dass zusätzliche externe Hardware-Komponenten benötigt werden.

**Kurze Figurenbeschreibung**

Nachfolgend wird ein vorteilhaftes Ausführungsbeispiel der Erfindung unter Bezugnahme auf die begleitenden Figuren erläutert. Es zeigen:

Fig. 1    ein Blockschaltbild einer elektronischen Schaltung 100 zur Ermittlung eines Ladezustands einer Batteriezelle eines Batteriesystems gemäß der Offenbarung;

Fig. 2    eine Darstellung eines zeitlichen Verlaufs 200 der Elektrolytkonzentration einer $LiFePO_4$ Batteriezelle gemäß einem Beispiel;

Fig. 3    eine Darstellung einer OCV-Kennlinie (Gleichgewichtsspannung) 300 einer $LiFePO_4$ Batteriezelle gemäß einem Beispiel;

Fig. 4    eine Darstellung der zeitlichen Änderung des Ladezustands 400 einer $LiFePO_4$-Batteriezelle gemäß einem Beispiel;

Fig. 5    eine Darstellung der Entladung 500 einer vollgeladenen $LiFePO_4$-Batteriezelle gemäß einem Beispiel;

Fig. 6    eine schematische Darstellung eines echtzeitfähigen Parameterschätzers und Zustandsbeobachters 600 gemäß einer beispielhaften Ausführungsform; und

Fig. 7    eine schematische Darstellung eines Verfahrens 700 zur Ermittlung eines Ladezustands einer Batteriezelle gemäß der Offenbarung.

Die Figuren sind lediglich schematische Darstellungen und dienen nur der Erläuterung der Erfindung. Gleiche oder gleichwirkende Elemente sind durchgängig mit den gleichen Bezugszeichen versehen.

In der folgenden ausführlichen Beschreibung wird auf die beiliegenden Zeichnungen Bezug genommen, die einen Teil hiervon bilden und in denen als Veranschaulichung spezifische Ausführungsformen gezeigt sind, in denen die Erfindung ausgeführt werden kann. Es versteht sich, dass auch andere Ausführungsformen genutzt und strukturelle oder logische Änderungen vorgenommen werden können, ohne von dem Konzept der vorliegenden Erfindung abzuweichen. Die folgende ausführliche Beschreibung ist deshalb nicht in einem beschränkenden Sinne zu verstehen. Ferner versteht es sich, dass die Merkmale der verschiedenen hierin beschriebenen Ausführungsbeispiele miteinander kombiniert werden können, sofern nicht spezifisch etwas anderes angegeben ist.

Die Aspekte und Ausführungsformen werden unter Bezugnahme auf die Zeichnungen beschrieben, wobei gleiche Bezugszeichen sich im Allgemeinen auf gleiche Elemente beziehen. In der folgenden Beschreibung werden zu Erläuterungszwecken zahlreiche spezifische Details dargelegt, um ein eingehendes Verständnis von einem oder mehreren Aspekten der Erfindung zu vermitteln. Für einen Fachmann kann es jedoch offensichtlich sein, dass ein oder mehrere Aspekte oder Ausführungsformen mit einem geringeren Grad der spezifischen Details ausgeführt werden können. In anderen Fällen werden bekannte Strukturen und Elemente in schematischer Form dargestellt, um das Beschreiben von einem oder mehreren Aspekten oder Ausführungsformen zu erleichtern. Es versteht sich, dass andere Ausführungsformen genutzt und strukturelle oder logische Änderungen vorgenommen werden können, ohne von dem Konzept der vorliegenden Erfindung abzuweichen.

In der folgenden Beschreibung wird auf Batteriezellen und das Batteriemanagementsystem (BMS) Bezug genommen. Damit Batteriezellen, beispielsweise Lithium-Ionen-Zellen sicher betrieben werden können, müssen die Zellspannungen und -temperaturen kontinuierlich überwacht werden. Dies geschieht über eine Überwachungselektronik, der Cell Supervision Electronics - oder kurz CSE. Die einzelnen Zellen in einer Batterie werden zu Zellmodulen zusammengefasst. Jedes Zellmodul verfügt über eine Überwachungselektronik, die CSE, an welche die Batteriezellen angeschlossen sind. Die CSE misst die Spannung und die Temperatur der Zellen.

Das BMS ist das zentrale Steuergerät einer Batterie. Beim BMS laufen die Informationen der einzelnen Zellüberwachungen, der CSEs, zusammen. Das BMS ermittelt anhand der Zellspannungen den aktuellen Ladezustand (SOC = State of Charge), gibt den Befehl zum Balancing und übernimmt die Kommunikation mit dem Fahrzeug. Außerdem wird sichergestellt, dass die Batteriezellen nicht überladen oder zu stark entladen werden.

In der folgenden Beschreibung wird Bezug genommen auf elektronische Schaltungen. Eine elektronische Schaltung ist ein Zusammenschluss von elektrischen und insbesondere elektronischen Bauelementen (beispielsweise Dioden und Transistoren) zu einer funktionierenden Anordnung. Elektronische Schaltungen können sehr einfache Funktionen erfüllen, wie z. B. das Blinken einer Lampe oder die Steuerung einer automatischen Tür. Aber auch vielen komplexen technischen Geräten, wie z. B. Computern oder elektrischen Fahrzeugen liegen elektronische Schaltungen zugrunde, häufig in Form von integrierten Schaltungen (ICs). Ein IC enthält typischerweise eine Kombination von zahlreichen miteinander elektrisch verbundenen elektronischen Halbleiterbauelementen wie Transistoren, Dioden und/oder weiteren aktiven und passiven Bauelementen.

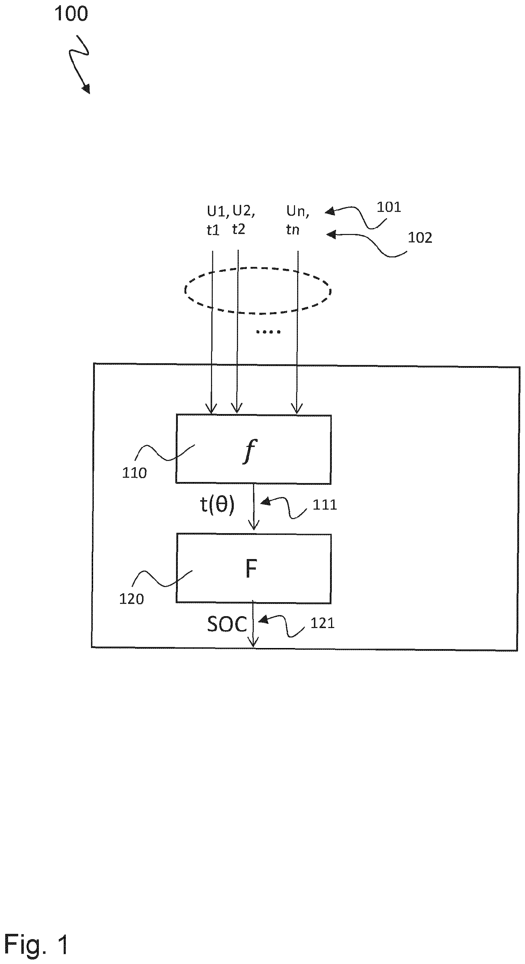

Fig. 1 zeigt ein Blockschaltbild einer elektronischen Schaltung 100 zur Ermittlung eines Ladezustands (SOC) einer Batteriezelle eines Batteriesystems gemäß der Offenbarung.

Die elektronische Schaltung 100 ist ausgebildet, eine Mehrzahl von Messwerten 101 einer Ruhespannung der Batteriezelle mit zugehörigen Zeitwerten 102, zu denen die Messwerte 101 der Ruhespannung erfasst wurden, zu erhalten. Sie kann die Messwerte 101 und die Zeitwerte 102 beispielsweise von einer anderen Schaltung erhalten, z.B. einem Controller eines Batteriemanagementsystems oder von einem Messsensor oder einer Messschaltung.

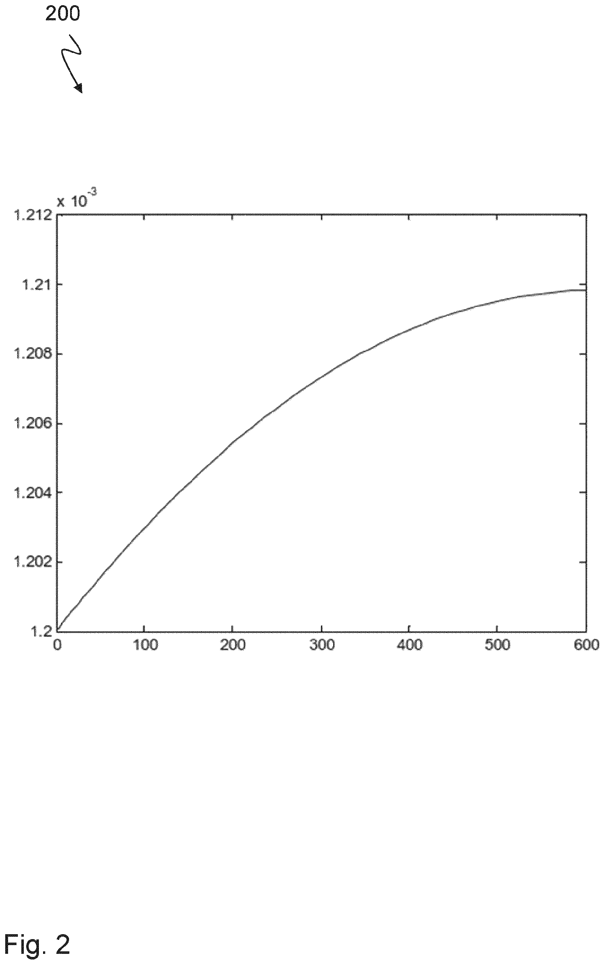

Die elektronische Schaltung 100 ist ausgebildet, eine Zeit 111, bis zu der ein zu einer Entladeschlussspannung der Batteriezelle zugehöriger Ladezustand, SOC 121 erreicht ist, basierend auf einer analytischen Lösung einer Funktion 110, welche einen Zusammenhang zwischen der Ruhespannung und dem Ladezustand 121 der Batteriezelle angibt, zu bestimmen. Die Bestimmung erfolgt in dem Block 110, welcher einen bestimmten Verarbeitungsschritt bzw. Verarbeitungsschritte anzeigen soll. Eine detaillierte Beschreibung dieser Verarbeitungsschritte wird im Folgenden angegeben, insbesondere bezüglich der Figuren 2 bis 6.

Die elektronische Schaltung 100 ist ausgebildet, den Ladezustand, SOC 121 der Batteriezelle basierend auf einer Umkehrfunktion 120 der ladezustandsabhängigen Zeit 111 zu ermitteln. Die Bestimmung erfolgt in dem Block 120, welcher einen bestimmten Verarbeitungsschritt bzw. Verarbeitungsschritte anzeigen soll. Auch hierzu wird eine detaillierte Beschreibung dieser Verarbeitungsschritte im Folgenden angegeben, insbesondere zu den Figuren 2 bis 6.

Die Funktion 110 kann auf einem elektrochemischen Modell der Batteriezelle basieren, wie unten zu den Figuren 2 bis 6 näher beschrieben.

Das elektrochemische Modell der Batteriezelle kann für einen unteren Bereich des Ladezustands aufgestellt sein. Es kann sich somit um ein reduziertes elektrochemisches Modell der Batteriezelle handeln, wie unten zu den Figuren 2 bis 6 näher dargestellt.

Der untere Bereich des Ladezustands kann beispielsweise Ladezustände kleiner als 50 Prozent umfassen.

Das elektrochemische Modell der Batteriezelle kann auf einer Butler-Volmer Gleichung beruhen, welche eine Beziehung einer Stromdichte der Batteriezelle in Bezug zu einer Potentialdifferenz zu einem Gleichgewichtspotential der Batteriezelle angibt, wie weiter unten ausführlich dargestellt.

Die oben genannte Funktion 110 kann den Ladezustand 121 abhängig von der Ruhespannung und einer Temperatur der Batteriezelle spezifizieren. Die Funktion 110 kann auf einer Logarithmus-Funktion basieren, die abhängig ist von dem Ladezustand 111 und der Temperatur.

Beispielsweise kann die Funktion 110 wie folgt bestimmt werden:

$$U_{OCV}(T, SOC) = K_0(T) + log\left(\left((SOC)(1 - SOC)\right)^{K_1(T)}\right)$$

wobei Uocv (T, SOC) einen zeitlichen Verlauf der Ruhespannung der Batteriezelle darstellt, welche abhängig ist von der Temperatur T und dem Ladezustand SOC und wobei $K_0(T)$ und $K_1(T)$ temperaturabhängige Parameter der Batteriezelle darstellen, wie unten zu den Figuren 2 bis 6 näher beschrieben.

Die analytische Lösung der Funktion 110 kann auf einer Ableitung der Zeit nach dem Ladezustand 121 basieren, beispielsweise wie im Folgenden dargestellt.

Die Ableitung der Zeit nach dem Ladezustand 121 kann sich beispielsweise wie folgt bestimmen:

$$\frac{dt(SOC)}{dSOC} = \frac{(SOC)^{-\beta}(1 - SOC)^{-\beta}}{j_{00}\, c_e^{\beta}\, \sinh\!\left[v\left(U_N - U_{OCV}(K_0, K_1, SOC, T)\right)\right]}$$

wobei t die Zeit darstellt, T die Temperatur, SOC den Ladezustand, Uocv die Ruhespannung, $K_0(T)$ und $K_1(T)$ temperaturabhängige Parameter der Batteriezelle, $c_e$ eine Elektrolytkonzentration der Batteriezelle, $j_{00}$ eine Austauschstromdichte bei Standardtemperatur von 25°C und $\beta$ einen Parameter der Batteriezelle darstellen. Eine genauere Beschreibung dieser Ableitung der Zeit nach dem Ladezustand findet sich hierzu unten zu den Figuren 2 bis 6.

Die elektronische Schaltung 100 kann ausgebildet sein, die Umkehrfunktion 120 der ladezustandsabhängigen Zeit basierend auf einem Newton-Verfahren zu bestimmen, wie unten näher beschrieben.

Die elektronische Schaltung 100 kann ausgebildet sein, einen Leistungszustand, SOP, der Batteriezelle basierend auf Basis der ermittelten Zeit 111, bis zu der ein zu einer Entladeschlussspannung der Batteriezelle zugehöriger Ladezustand 121 erreicht ist, zu bestimmen.

Die elektronische Schaltung 100 kann ausgebildet sein, einen stromunabhängigen Innenwiderstand der Batteriezelle auf Basis des ermittelten Ladezustands 121 zu bestimmen.

Die elektronische Schaltung 100 kann ausgebildet sein, auf Basis der analytischen Lösung der Funktion 110 einen Zustandsbeobachter mit Kalman-Filter zu erzeugen und ein oder mehrere Zustände der Batteriezelle zu beobachten.

Die elektronische Schaltung 100 kann ausgebildet sein, auf Basis der analytischen Lösung der Funktion 110 ein oder mehrere Parameter eines Ersatzschaltbildmodells der Batteriezelle zu bestimmen.

Die elektronische Schaltung kann in einem Batteriemanagementsystem, beispielsweise eines Fahrzeugs, eingesetzt werden. Ein solches Batteriemanagementsystem umfasst beispielsweise einen Controller zur Erfassung einer Mehrzahl von Messwerten 101 einer Ruhespannung einer Batteriezelle eines Batteriesystems mit zugehörigen Zeitwerten 102, zu denen die Messwerte 101 der Ruhespannung erfasst wurden; und eine elektronische Schaltung 100 wie oben beschrieben zur Bestimmung des Ladezustands 121 der Batteriezelle.

Im Folgenden wird eine Lösung für eine Verbesserung des Standardzellmodells (elektrochemisches Modell) präsentiert, welche eine Erweiterung des Gültigkeitsbereiches bzw. der Genauigkeit liefert. Erstmalig konnte dieses Modell gelöst werden und eine geschlossene und analytische Lösung angegeben werden, wie im Folgenden aufgezeigt.

Die Butler-Volmer Stromdichte lautet:

$$j^{Li}(x) = a_s j_0 \left(e^{v\eta} - e^{-v\eta}\right)$$

Darin ist as die aktive Oberfläche pro Elektrode und Volumen. $j_0$ ist die Austauschstromdichte und $\eta$ die Überspannung.

Die Austauschstromdichte lässt sich wie folgt schreiben:

$$j_0 = j_{00}\, k_T (c_e)^{\alpha_a} \left(c_{s,max} - c_{se}\right)^{\alpha_a} (c_{se})^{\alpha_c}$$

Die Parameter $a_a$, $a_c$ sind die Ladungsübertragungskoeffizienten der Anode und Kathode und prinzipiell frei wählbar. Des Weiteren bedeuten $c_{s,max}$ die maximale Konzentration der festen Phase (Lithium-Ionen-Konzentration), $c_{se}$ Konzentration der festen Phase an der Schnittstelle zum Elektrolyten und $c_e$ die Elektrolytkonzentration. Die Standardaustauschstromdichte $j_{00}$ ist die Austauschstromdichte, die sich bei Standardtemperatur von 25°C einstellt. Der Faktor $k_T$ berücksichtigt den Einfluss der Temperatur und hat bei Standardtemperatur $T_0 = 25°C$ den Wert 1. Die Überspannung

$$\eta = \phi - U$$

ergibt sich aus dem Potential $\phi$ und der Gleichgewichtsspannung U, die eine Funktion der Lithium - Konzentration an der Schnittstelle zum Elektrolyten ist.

Die Zustandsgrößen wie z.B. $\phi$ werden durch gekoppelte, partielle Differentialgleichungen, die sowohl vom Ort (horizontale Effekte) und der Zeit abhängen, beschrieben. Beim Übergang zu dem hier verwendeten reduzierten elektrochemischen Modell wird die Ortabhängigkeit $x$ in der Stromdichte durch einen mittleren Strom ersetzt. Für die Anode ergibt sich z.B. (und entsprechend für Kathode):

$$\int_0^{\delta_n} j^{Li}(x)\, dx = \frac{I}{A} = |j_n{}^{Li}|\delta_n$$

Wobei $\delta_n$ die Dicke und $A$ die Fläche der positiven Elektrode ist. Die Annahme wurde mittels einer Simulation mit dem reduzierten elektrochemischen Modell für eine LiFePO$_4$-Zelle überprüft.

Im Folgenden wird ein reduziertes physikalisches Modell hergeleitet, welches unter bestimmten Bedingungen exakt analytisch lösbar ist. Dies ist derzeit nur bei den ECM-Modellen (1/2 RC) für eine spezielle Lösung der inhomogenen Differentialgleichung möglich.

Die Parameter des ECM-Modells sind dabei nicht nur Temperatur, sondern auch SOC abhängig.

Für eine einfachere Darstellung des Verfahrens wird hier nur die Entladerichtung betrachtet. Beschrieben wird hier nicht die Lithium-Ionen-Konzentration, sondern der daraus abgeleitete Ladezustand. Im Folgenden sollen folgende Parameter festgelegt werden:

$$j_{00} = 2, \qquad k_T = 1, \qquad \alpha_a = \alpha_c = \beta = \frac{1}{2}$$

Diese Festlegungen sind jedoch grundsätzlich keine notwendige Bedingung für das hier dargestellte Verfahren, d.h. z.B. die Ladungsübertragungskoeffizienten sind frei wählbar.

Die folgenden Bedingungen sind derzeit noch zwingend:

1.) Migrationseffekte bei der Elektrolytkonzentration werden nicht berücksichtigt. Darüber hinaus wird die Konzentration des Elektrolyten als annähernd konstant angenommen.

$$c_e = const$$

Fig. 2 zeigt eine Darstellung des zeitlichen Verlaufs 200 der Elektrolytkonzentration einer LiFePO$_4$ Batteriezelle gemäß einem Beispiel.

Insbesondere zeigt die Abbildung den zeitlichen Verlauf der Elektrolytkonzentration einer vollgeladenen 16 Ah LiFePO4 - Zelle, die mit 90 A bis zur Entladeschlussspannung entladen wird. Die Änderung gegenüber dem Anfangswert der Konzentration beträgt 0.83 %.

2.) Die unmittelbare Umgebungstemperatur bzw. Modul- oder Kühltemperatur entspricht der Zelltemperatur. Es wird kein thermisches Modell für die Berechnung der Zelltemperatur aus der Umgebungstemperatur berücksichtigt.

3.) Weiterhin werden die Gleichgewichtsspannungen der positiven und negativen Elektrode durch die gesamte Gleichgewichtsspannung Uocv ersetzt. Die Gleichgewichtsspannung für die einzelnen Elektroden sind eh und je nur durch Messungen mit sogenannten Halbzellen verfügbar. Uocv kann mit einzelnen Batteriezellen entweder vermessen oder aus einem Zelldatenblatt entnommen werden.

Der entscheidende Ansatz für dieses Verfahren ist, dass für den unteren SOC-Bereich $0\% \leq SOC \leq 50\%$ die Ruhespannungskennline bei Lithium-Ionen-Zellen mit verschiedenen Kathodenmaterialen hinreichend genau durch die folgende Funktion beschrieben werden kann:

$$U_{OCV}(T, SOC) = K_0(T) + log\left(\left((SOC)(1 - SOC)\right)^{K_1(T)}\right)$$

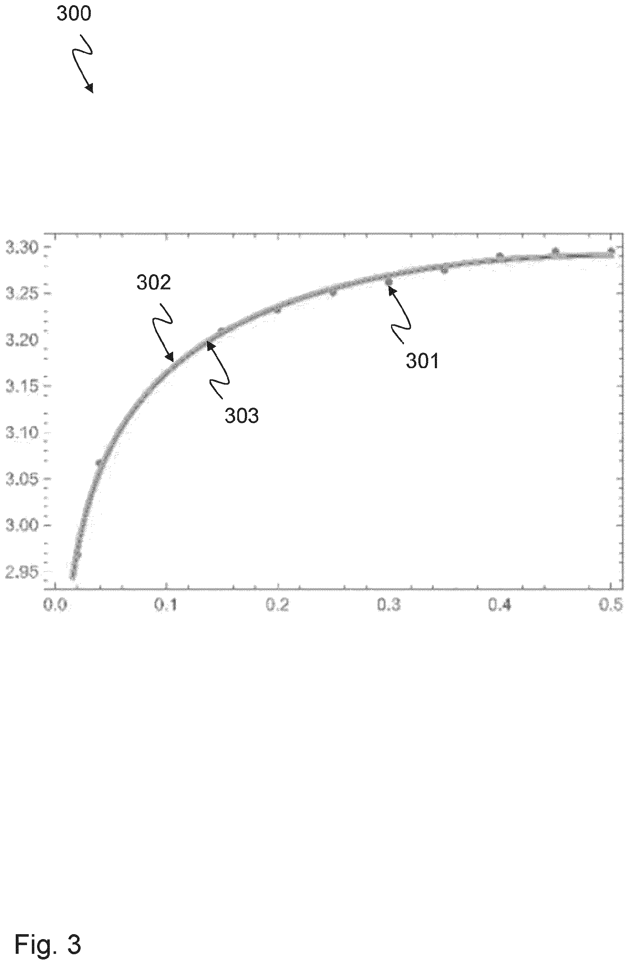

Figur 3 zeigt den optimalen Fit der Funktion Uocv mit den Messdaten z.B. einer Lithium-Eisenphosphat-Zelle (LiFePO4) für die Parameter

$$K_0 = 3.4636 \qquad K_1 = 0.1246 \quad bei\ 25°C$$

Zu sehen sind die Messpunkte 301, der Fit mit den Parametern $K_0$, $K_1$ (durchgezogene Kurve 302) und für eine einfachere Darstellung des komplexen Verfahrens der Fit mit der Näherung des Parameters $K_1$ (gestrichelte Kurve 303), speziell für die Technologie LiFePO$_4$, bei der die Alterung der OCV keine wesentliche Rolle spielt. Das Verfahren ist natürlich auch auf jede Zelltechnologie mit anderen Parametern anwendbar. In diesem Fall können sich die Parameter mit der Alterung noch ändern.

Die Parameter $K_0$, $K_1$ der Ruhespannungskennline Uocv können dann mittels des bekannten Verfahrens "Regression" online in Abhängigkeit von der Alterung, dem Ladezustand und der Temperatur der Zelle bestimmt werden.

Für die notwendigen Bedingungen und Festlegungen soll hier die Differentialgleichung zur Beschreibung einer Zustandsgröße abgeleitet werden, die einerseits für eine neue SOP-Funktion als auch für den Kalman-Filter verwendet werden kann. Abschließend soll hier die Lösung der Differentialgleichung skizziert werden. Diese Lösung beschreibt Parameter, die als rationale Zahlen z.B. $K_1$ = p/q dargestellt werden können. Dies ist jedoch keine notwendige Bedingung, da es auch eine allgemeinere Lösung für Parameter gibt, die durch reelle Zahlen beliebiger Genauigkeit beschrieben werden können. Für eine einfachere Darstellung des komplexen Verfahrens wird hier darauf verzichtet.

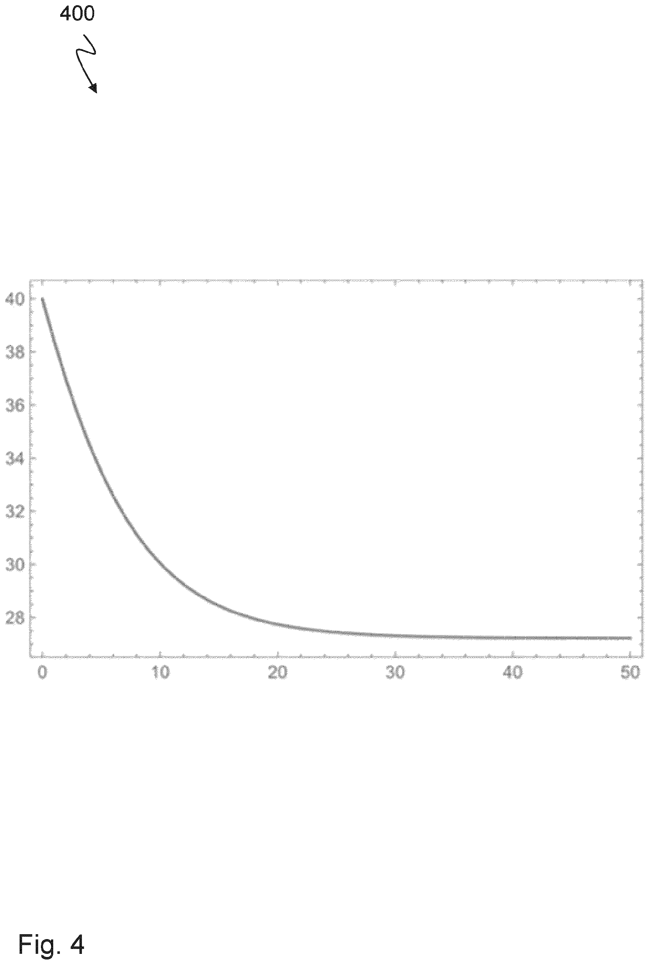

Es wird nun der Strom betrachtet, beschrieben durch die Butler-Volmer-Gleichung, der nun von der Zeit, einer vorgegebenen Spannung und von dem SOC abhängig ist. Diese Gleichung wird in die Differentialgleichung für die zeitliche Änderung der Lithium-Ionen-Konzentration eingesetzt und stattdessen der Ladezustand verwendet. Nach Integration ergibt sich für eine vorgegebene Zeit und Spannung der entsprechende Ladezustand, siehe Figur 4. Diese Beschreibung entspricht einer CCCV-Entladung mit einem unbegrenzten Strom, wie man experimentell mittels einer spannungsgesteuerten Entladung und entsprechender Last validieren kann.

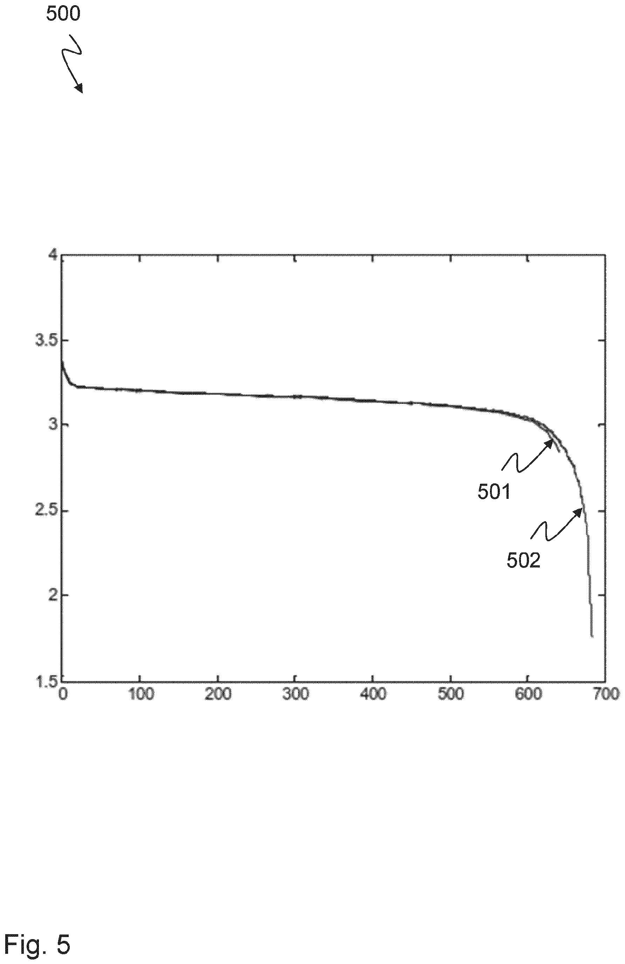

Damit ist der SOC eindeutig bestimmt. Figur 5 zeigt das entsprechende Ergebnis der Simulation. Deutlich ist der Übergang von der Konstant-Strom zur Konstant-Spannung zu erkennen. Durch Invertierung der Buttler-Volmer-Gleichung lässt sich auch ein stromgesteuertes Modell realisieren, welches in der numerischen Simulation des reduzierten Modells verwendet wird. Der Vergleich der gemessenen und simulierten Spannung für eine LiFePO4-Zelle ist in Figur 5 dargestellt, welche die Entladung 500 einer vollgeladenen LiFePO$_4$-Batteriezelle gemäß einem Beispiel darstellt.

Für die folgende Betrachtung wird von dem spannungsgesteuerten Modell ausgegangen und es wird statt der zeitlichen Änderung des Ladezustandes die inverse Gleichung betrachtet:

$$\frac{dt(SOC)}{dSOC} = \frac{(SOC)^{-\beta}(1-SOC)^{-\beta}}{j_{00}\, c_e{}^{\beta}\, \sinh\left[v\left(U_N - U_{OCV}(K_0, K_1, SOC, T)\right)\right]}$$

wobei der Parameter v durch

$$v = \alpha_a \frac{F}{R\,T}$$

F die Faraday-Konstante, R die allgemeine Gaskonstante und $a_a$ der Ladungsübertragungskoeffizient ist. Im Folgenden wird der Einfachheit halber die folgende Ersetzung vorgenommen: $\theta = SOC$. Die Lösung dieser Differentialgleichung kann mittels U$_{OCV}$($K_0$, $K_1$, *SOC, T*) durch die folgenden Integrale beschrieben werden:

$$\tau = \int_{\theta_0}^{\theta_1} \frac{\theta_0(\theta(1-\theta))^{-\beta}}{(1-(b\,\theta(1-\theta))^{\kappa})}\, d\theta - \int_{\theta_0}^{\theta_1} \frac{(\theta(1-\theta))^{-\beta}}{(1-(b\,\theta(1-\theta))^{\kappa})}\, d\theta$$

Hierbei ist

$$\tau = j_{00}\, c_e{}^{\beta}\, t \qquad \kappa = K_1(T)\, v \qquad b = e^{\frac{(K_0(T)-U_N)}{K_1(T)}}$$

$\tau$ eine neue Zeitskala, die Parameter $b$ und $\kappa$ zwei charakteristische Parameter, die von der Temperatur und Alterung abhängig sind. Die einzelnen Integrale können mittels elementarer mathematischer Transformationen wie z.B. die Substitution eines bestimmten Integrals weiter vereinfacht werden. Dies wird hier nicht weiter ausgeführt, da hier nur eine Kurzfassung beschrieben wird. Am Ende lässt sich das Integral in eine Summe von vier folgenden, elementaren Integralen lösen, die in der verallgemeinerten Form sich wie folgt darstellen:

$$\int_0^\infty \frac{x^{\lambda-1}}{(1+x)^\mu} S\left[\begin{matrix}\begin{bmatrix}p, & o\\ A-p, & B\end{bmatrix}\\ \begin{pmatrix}q, & r\\ C-q, & D-r\end{pmatrix}\\ \begin{pmatrix}k, & l\\ E-k, & F-l\end{pmatrix}\end{matrix}\middle| \begin{matrix}(a);(b)\\ (c);(d)\\ (e);(f)\end{matrix}\middle| \begin{matrix}v\left\{\frac{x}{1+x}\right\}^\varrho\\ \omega\left\{\frac{x}{1+x}\right\}^\varrho\end{matrix}\right] dx$$

$$= \frac{\Gamma(\mu-\lambda)}{\varrho^{(\mu-\lambda)}} S\left[\begin{matrix}\begin{bmatrix}p+\varrho, & o\\ A-p, & B+\varrho\end{bmatrix}\\ \begin{pmatrix}q, & r\\ C-q, & D-r\end{pmatrix}\\ \begin{pmatrix}k, & l\\ E-k, & F-l\end{pmatrix}\end{matrix}\middle| \begin{matrix}\Delta(\varrho,\lambda),(a);\Delta(\varrho,\mu),(b)\\ (c);(d)\\ (e);(f)\end{matrix}\middle| \begin{matrix}v\\ \omega\end{matrix}\right]$$

wie in "Shah, M.: 'On generalization of some results and their applications' Collectanea Mathematica, 1973, 24, (3), pp. 249-266" beschrieben. Bei der Funktion handelt es sich um eine Verallgemeinerung von Meijers G-Funktion die von SHARMA wie folgt eingeführt wurde:

$$S\begin{bmatrix}x\\ y\end{bmatrix} = S\left[\begin{matrix}\begin{bmatrix}b, & o\\ A-p, & B\end{bmatrix}\\ \begin{pmatrix}q, & r\\ C-q, & D-r\end{pmatrix}\\ \begin{pmatrix}k, & l\\ E-k, & F-l\end{pmatrix}\end{matrix}\middle| \begin{matrix}(a);(b)\\ (c);(d)\\ (e);(f)\end{matrix}\middle| \begin{matrix}x\\ y\end{matrix}\right] = \frac{1}{(2\pi i)^2}\int_{L_1}\int_{L_2}\Phi(\xi+\eta)\Psi(\xi,\eta)\,x^\xi y^\eta d\xi d\eta$$

wobei gilt:

(i) A, B, C etc., sind nicht negative ganze Zahlen und erfüllen die folgenden Ungleichungen:

$$D \geq 1, F \geq 1, A \geq 1, B \geq 1, o \leq q \leq C, o \leq k \leq E,$$

$$o \leq r \leq D, o \leq l \leq F, A + C \leq B + D \text{ und } A + E \leq B + F$$

(ii) die Notation ($a$) steht für einen Satz von A-Parametern

$$a_1, a_2, \ldots , a_p; a_{p+1}, \ldots a_a$$

mit gleicher Bedeutung für ($b$) ($c$) ($d$) ($e$) und (f);
(iii) $L_1$ und $L_2$ sind passende Konturen
(iv)

$$\Delta(\varrho, \lambda) = \frac{\lambda}{\varrho}, \frac{\lambda+1}{\varrho}, \dots, \frac{\lambda+\varrho-1}{\varrho}$$

Diese Ableitung hat den Vorteil, dass Shah bereits einen mathematischen Beweis veröffentlicht hat. Alternativ wurde vom Autor ursprünglich eine eigene Ableitung hergeleitet, die jedoch sehr aufwendig in der Darstellung ist. Die numerische Berechnung wurde bereits veröffentlicht als EGBMGF Funktion, konnte aber vom Autor nicht validiert werden. Es existiert eine andere Definition im Original von R.P.Agarwal 1964, die in die von SHARMA mit *"integration - Definite integral involving algebraic, exponential, and product of two Meijer's G function - Mathematics Stack Exchange"* überführt werden kann. Diese wurde veröffentlicht und verifiziert in *"Extended Generalized Bivariate Meijer G-Function results don't match? - Online Technical Discussion Groups-Wolfram Community"*.

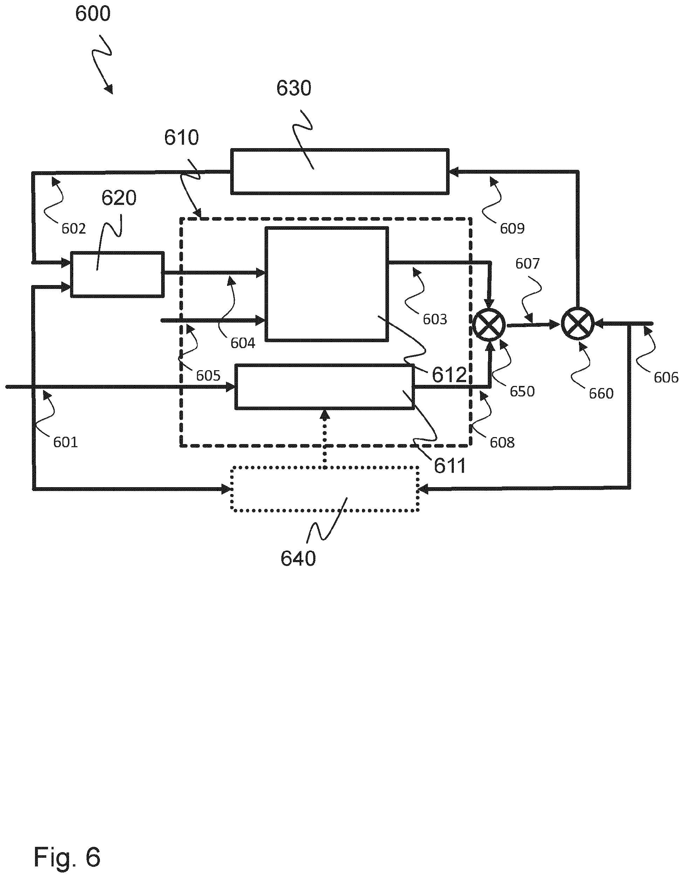

Fig. 6 zeigt eine schematische Darstellung eines echtzeitfähigen Parameterschätzers und Zustandsbeobachters 600 gemäß einer beispielhaften Ausführungsform.

Eine Ruhespannungskennlinie 610 wird durch die beiden Blöcke 612 und 611 gebildet. Der erste Block 612 beschreibt eine vorgegebene Kennlinie, welche aus den beiden Eingängen Ladezustand, SOC $(t_n)$, 604 und Temperatur $T(t_n)$, 605 die Ruhespannung $U_{OCV}(t_n)$ 603 bestimmt. Der zweite Block 611 beschreibt das dynamische Zellmodell, welches aus dem Strom-Eingang $I(t_n)$ 601 den Spannungsausgang $U_{OCV}(t_n)$ 608 bestimmt. Beide Spannungsausgänge 608 und 603 werden miteinander kombiniert 650, um daraus die simulierte Spannung $U_{SIM}(t_n)$ zur Zeit $t_n$ zu bestimmen, welche mit der gemessenen Spannung $U_{MESS}(t_n)$, 606, zur Zeit $t_n$ verglichen 660 wird, um eine Differenzspannung 609 zur Zeit $t_n$ zu erhalten. Diese Differenzspannung 609 wird durch das adaptive erweiterte Kalman-Filter 630 verarbeitet, um den optimalen Ladezustand $SOC_{opt}(t_{n-1})$, 602, zu der Zeit $t_{n-1}$ zu erhalten. In dem Block 620 "Coulomb Counting" wird der Ladezustand $SOC_{opt}(t_n)$, 604, zu der Zeit $t_n$ aus dem optimalen Ladezustand $SOC_{opt}(t_{n-1})$, 602, zu der Zeit $t_{n-1}$ und dem Strom-Eingang $I(t_n)$ 601 mittels "Coulomb Counting" bestimmt. Ein optionaler Parameterschätzer 640 kann genutzt werden, um online die Parameter des dynamischen Zellmodells 611 anzupassen. Als Eingänge für den Parameterschätzer 640 dienen der Strom-Eingang $I(t_n)$ 601 und die gemessene Spannung $U_{MESS}(t_n)$, 606, zur Zeit $t_n$.

Insbesondere zeigt Figur 6 das allgemeine Diagramm des reduzierten elektrochemischen Modells und das Zusammenspiel von zwei Algorithmen, dem Parameterschätzer und dem adaptiven erweiterten Kalman Filter, der auf der Grundlage der oben beschriebenen Funktion entwickelt werden kann.

Die Parameter der Funktion sind in Abhängigkeit von der Temperatur in einer Tabelle hinterlegt. Da sich die Parameter jedoch auch mit der Alterung verändern können, müssen nach einer gewissen Zeit z.B. jeden Monat die Parameter mittels eines Parameterschätzers entweder direkt auf dem Mikrocontroller oder Offline mittels einer Cloud-Anbindung (zum Beispiel BMS2Cloud) neu bestimmt werden. Im ersten Fall ist aufgrund der geringeren Anzahl von frei wählbaren Parametern bei dem reduzierten Modell und wegen der Existenz der geschlossenen Lösung die Parameterbestimmung weniger zeit- und rechenintensiv. In anderen Publikationen, bei denen ein physikalisches dynamisches Zellmodell beim Kalman-Filter für den Aufbau eines Zustandsbeobachter verwendet wird, wird auf die Abhängigkeit der Parameter von der Alterung zwar hingewiesen, aber der Parameterschätzer aufgrund der Komplexität gar nicht betrachtet. Es ist nur bekannt, dass bei den digitalen Zwillingen eine alterungsbedingte Parameteranpassung des physikalischen Modells erfolgt.

Die Lösung des Integrals

$$t(\theta) = f\left\{ S \begin{bmatrix} \upsilon & \theta^\varrho \\ \omega & \theta^\varrho \end{bmatrix} \right\}$$

liefert die Zeit t bis ein Ladezustand zu einer bestimmten unteren Entladeschlussspannung erreicht ist. Die Umkehrfunktion

$$\theta(t) = f^{-1}\left\{ S \begin{bmatrix} \upsilon & \theta^\varrho \\ \beta & \omega^\varrho \end{bmatrix} \right\} := F(t)$$

kann mittels des Newton-Verfahrens numerisch bestimmt werden und liefert den Ladezustand der Batterie. Mit Hilfe der Funktion *F*(*t*) kann sowohl die Spannung in der CC als auch der Strom in der CV (Grenzstrom) bestimmt werden.

Bisher ist die Funktion *F*(*t*) unbekannt. Es geht insbesondere darum, mit Hilfe eines mathematischen Instrumentenkastens (Reihenentwicklung etc.) ein besseres Verständnis über die Eigenschaften der Funktion zu entwickeln. Diese ermöglicht z.B. zahlreiche Innovationen wie z.B. die Ableitung mit dem Modell eines n-RC ECM-Modells zu vergleichen und daraus Rückschlüsse abzuleiten zwischen den ECM-Parametern und den Parametern des EMs. Die Lösung $t(\theta)$ liefert bereits wertvolle Informationen und lässt sich als SOP Funktion in der beschriebenen Weise nutzen. Eine Vielzahl von Anwendungen können wie folgt zusammengefasst werden:

1) SOP Funktion und Kalman-Filter auf der Basis des $t(\theta)$ aufbauen. Die Zeit kann unmittelbar für beliebige Werte $\theta$ berechnet werden. Hierfür muss das Modell im Gegensatz zu anderen bekannten Lösungen nicht in einem bestimmten Zustand mit der Schrittweite $\Delta h$ simuliert werden. $t(\theta)$ liefert dabei zusätzliche Informationen über das charakteristische Verhalten der Zelle/Batterie.

2) Die Funktion $t(\theta)$ für eine alterungsabhängige Parameterbestimmung verwenden. Andere bekannte Lösungen sind sehr rechenintensiv und die Umsetzung auf einem Steuergerät kaum praktikabel.

3) $\theta(t)$ mittels eines Newton-Verfahrens bestimmen, simulierten Strom berechnen und in einem Kalman-Filter und SOP-Funktion verwenden. Eine spannungsgesteuerte Lösung ist hier nicht bekannt.

4) $\theta(t)$ mittels eines Newton-Verfahrens bestimmen, die simulierte Spannung berechnen und in einem Kalman-Filter verwenden. Dies liefert die höhere Genauigkeit wegen des elektrochemischen Modells bei gleichzeitig niedrigerem Rechen- und Speicherbedarf.

5) $\theta(t)$ mittels eines Newton-Verfahrens bestimmen. Mit Hilfe des berechneten Stroms und der berechneten Spannung einen stromunabhängigen Innenwiderstand zu jeder beliebigen unteren Entladeschlussspannung bestimmen.

6) Das neue analytische Modell mit dem bekannten ECM-Modell vergleichen, um so Rückschlüsse auf die SOC abhängigen ECM-Parameter zu gewinnen.

Die Funktion $t(\theta)$ liefert neue Informationen über den Zustand der Zellen/Batterie, die für die Bewertung der Alterung mit herangezogen werden können.

Für die SOC-Bestimmung liefert das hier vorgestellte Verfahren gegenüber den bekannten Lösungen einige Vorteile hinsichtlich einer wenig speicher- und rechenintensiven Methode bei gleichzeitig hoher SOC-Genauigkeit.

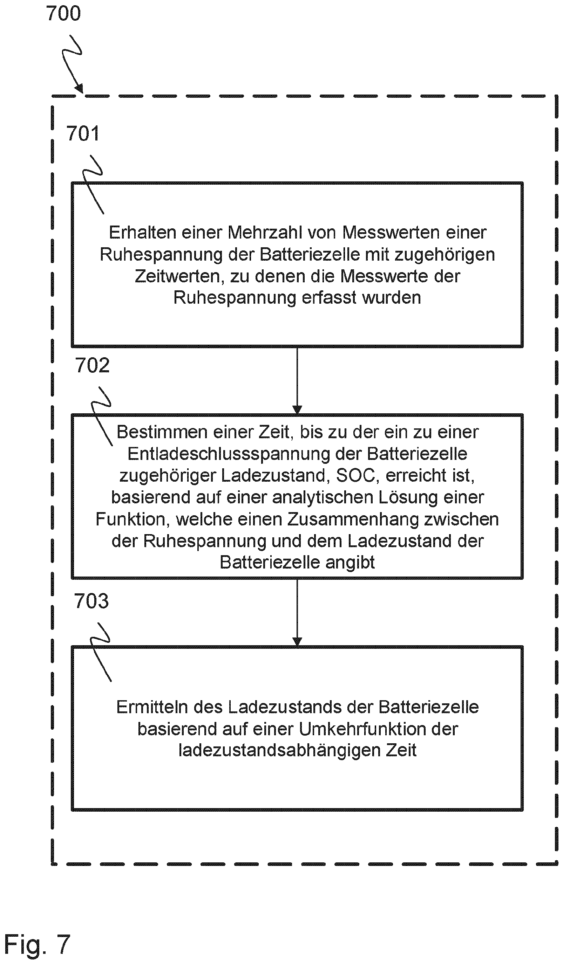

Fig. 7 zeigt eine schematische Darstellung eines Verfahrens 700 zur Ermittlung eines Ladezustands einer Batteriezelle eines Batteriesystems gemäß der Offenbarung. Das Batteriesystem kann beispielsweise ein Batteriesystem eines elektrischen Fahrzeugs sein.

Das Verfahren 700 umfasst die folgenden Schritte: Erhalten 701 einer Mehrzahl von Messwerten 101 einer Ruhespannung der Batteriezelle mit zugehörigen Zeitwerten 102, zu denen die Messwerte 101 der Ruhespannung erfasst wurden; Bestimmen 702 einer Zeit 111, bis zu der ein zu einer vorgegebenen Entladeschlussspannung der Batteriezelle zugehöriger Ladezustand, SOC 121 erreicht ist, basierend auf einer analytischen Lösung einer Funktion 110, welche einen Zusammenhang zwischen der Ruhespannung und dem Ladezustand 121 der Batteriezelle angibt; und Ermitteln 703 des Ladezustands 121 der Batteriezelle basierend auf einer Umkehrfunktion 120 der ladezustandsabhängigen Zeit 111.

Ferner kann ein Computerprogramm mit einem Programmcode zum Ausführen des Verfahrens 700 auf einer elektronischen Schaltung 100 oder einem Batteriemanagementsystem, wie oben zu Figur 1 beschrieben, bereitgestellt werden.

BEZUGSZEICHENLISTE

| | |
|---|---|
| 100 | elektronische Schaltung |
| 101 | Messwerte der Ruhespannung der Batteriezelle |
| 102 | zugehörige Zeitwerte, zu denen die Messwerte der Ruhespannung erfasst wurden |
| 110 | Funktion, welche Zusammenhang zwischen Ruhespannung und Ladezustand angibt |
| 111 | Zeit bis zu der ein zu einer Entladeschlussspannung der Batteriezelle zugehöriger Ladezustand erreicht ist |
| 120 | Umkehrfunktion |
| 121 | Ladezustand der Batteriezelle |

200   Elektrolytkonzentration einer LiFePO4-Zelle

300   OCV Kennlinie einer LiFePO4-Zelle

400   zeitliche Änderung des Ladezustands einer LiFePO4-Zelle

500   Entladung einer vollgeladenen LiFePO4-Zelle
501   Simulation
502   Messung

600   schematische Darstellung eines echtzeitfähigen Parameterschätzers und Zustandsbeobachters
601   Strom
602   optimaler Ladezustand zum Zeitpunkt $t_{n-1}$
603   Ruhespannung
604   Ladezustand zum Zeitpunkt $t_n$
605   Temperatur
606   Messung der Spannung
607   Simulation der Spannung
608   Spannung des Zellmodells
609   Spannungsdifferenz zwischen Simulation und Messung
610   Batteriemodell (reduziertes elektrochemisches Modell)
611   dynamisches Zellmodell
612   Ruhespannungskennlinie
620   Coulomb-Zählung (Coulomb-Counting)
630   adaptiver erweiterter Kalman-Filter

700   Verfahren zur Ermittlung eines Ladezustands
701   erster Verfahrensschritt
702   zweiter Verfahrensschritt
703   dritter Verfahrensschritt


**Patentansprüche**

1.   Elektronische Schaltung (100) zur Ermittlung eines Ladezustands (121), SOC, einer Batteriezelle eines Batteriesystems, wobei die elektronische Schaltung (100) ausgebildet ist,

   eine Mehrzahl von Messwerten (101) einer Ruhespannung der Batteriezelle mit zugehörigen Zeitwerten (102), zu denen die Messwerte (101) der Ruhespannung erfasst wurden, zu erhalten;
   eine Zeit (111), bis zu der ein zu einer Entladeschlussspannung der Batteriezelle zugehöriger Ladezustand, SOC (121) erreicht ist, basierend auf einer analytischen Lösung einer Funktion (110), welche einen Zusammenhang zwischen der Ruhespannung und dem Ladezustand (121) der Batteriezelle angibt, zu bestimmen; und den Ladezustand, SOC (121) der Batteriezelle basierend auf einer Umkehrfunktion (120) der ladezustandsabhängigen Zeit (111) zu ermitteln.

2.   Elektronische Schaltung (100) nach Anspruch 1,
   wobei die Funktion (110) auf einem elektrochemischen Modell der Batteriezelle basiert.

3.   Elektronische Schaltung (100) nach Anspruch 2,
   wobei das elektrochemische Modell der Batteriezelle für einen unteren Bereich des Ladezustands aufgestellt ist.

4.   Elektronische Schaltung (100) nach Anspruch 3,
   wobei der untere Bereich des Ladezustands Ladezustände kleiner als 50 Prozent umfasst.

5.   Elektronische Schaltung (100) nach einem der Ansprüche 2 bis 4,
   wobei das elektrochemische Modell der Batteriezelle auf einer Butler-Volmer Gleichung beruht, welche eine Beziehung einer Stromdichte der Batteriezelle in Bezug zu einer Potentialdifferenz zu einem Gleichgewichtspotential der Batteriezelle angibt.

6. Elektronische Schaltung (100) nach einem der vorstehenden Ansprüche,
   wobei die Funktion (110) den Ladezustand (121) abhängig von der Ruhespannung und einer Temperatur der Batteriezelle spezifiziert.

7. Elektronische Schaltung (100) nach einem der vorstehenden Ansprüche,
   wobei die Funktion (110) auf einer Logarithmus-Funktion basiert, die abhängig ist von dem Ladezustand (111) und der Temperatur.

8. Elektronische Schaltung (100) nach Anspruch 7,

   wobei die Funktion (110) sich wie folgt bestimmt:

$$U_{OCV}(T, SOC) = K_0(T) + log\left(\left((SOC)(1 - SOC)\right)^{K_1(T)}\right)$$

   wobei Uocv (T, SOC) einen zeitlichen Verlauf der Ruhespannung der Batteriezelle darstellt, welche abhängig ist von der Temperatur T und dem Ladezustand SOC und wobei $K_0(T)$ und $K_1(T)$ temperaturabhängige Parameter der Batteriezelle darstellen.

9. Elektronische Schaltung (100) nach einem der vorstehenden Ansprüche,
   wobei die analytische Lösung der Funktion (110) auf einer Ableitung der Zeit nach dem Ladezustand (121) basiert.

10. Elektronische Schaltung (100) nach Anspruch 9,

   wobei die Ableitung der Zeit nach dem Ladezustand (121) sich wie folgt bestimmt:

$$\frac{dt(SOC)}{dSOC} = \frac{(SOC)^{-\beta}(1 - SOC)^{-\beta}}{j_{00} \, c_e^{\beta} \, \sinh\left[v\left(U_N - U_{OCV}(K_0, K_1, SOC, T)\right)\right]}$$

   wobei t die Zeit darstellt, T die Temperatur, SOC den Ladezustand, Uocv die Ruhespannung, $K_0(T)$ und $K_1(T)$ temperaturabhängige Parameter der Batteriezelle, $c_e$ eine Elektrolytkonzentration der Batteriezelle, $j_{00}$ eine Austauschstromdichte bei Standardtemperatur von 25°C und $\beta$ einen Parameter der Batteriezelle darstellen.

11. Elektronische Schaltung (100) nach einem der vorstehenden Ansprüche,
   welche ausgebildet ist, die Umkehrfunktion (120) der ladezustandsabhängigen Zeit basierend auf einem Newton-Verfahren zu bestimmen.

12. Elektronische Schaltung (100) nach einem der vorstehenden Ansprüche,
   welche ausgebildet ist, einen Leistungszustand, SOP, der Batteriezelle basierend auf Basis der ermittelten Zeit (111), bis zu der ein zu einer Entladeschlussspannung der Batteriezelle zugehöriger Ladezustand (121) erreicht ist, zu bestimmen.

13. Elektronische Schaltung (100) nach einem der vorstehenden Ansprüche,
   welche ausgebildet ist, einen stromunabhängigen Innenwiderstand der Batteriezelle auf Basis des ermittelten Ladezustands (121) zu bestimmen.

14. Elektronische Schaltung (100) nach einem der vorstehenden Ansprüche,
   welche ausgebildet ist, auf Basis der analytischen Lösung einer Funktion (110) einen Zustandsbeobachter mit Kalman-Filter zu erzeugen und ein oder mehrere Zustände der Batteriezelle zu beobachten.

15. Elektronische Schaltung (100) nach einem der vorstehenden Ansprüche,
   welche ausgebildet ist, auf Basis der analytischen Lösung der Funktion (110) ein oder mehrere Parameter eines Ersatzschaltbildmodells der Batteriezelle zu bestimmen.

16. Batteriemanagementsystem mit:

einem Controller zur Erfassung einer Mehrzahl von Messwerten (101) einer Ruhespannung einer Batteriezelle eines Batteriesystems mit zugehörigen Zeitwerten (102), zu denen die Messwerte (101) der Ruhespannung erfasst wurden; und

einer elektronischen Schaltung (100) nach einem der vorstehenden Ansprüche zur Bestimmung des Ladezustands (121) der Batteriezelle.

17. Verfahren (700) zur Ermittlung eines Ladezustands (121), SOC, einer Batteriezelle eines Batteriesystems, wobei das Verfahren (700) die folgenden Schritte aufweist:

Erhalten (701) einer Mehrzahl von Messwerten (101) einer Ruhespannung der Batteriezelle mit zugehörigen Zeitwerten (102), zu denen die Messwerte (101) der Ruhespannung erfasst wurden;

Bestimmen (702) einer Zeit (111), bis zu der ein zu einer vorgegebenen Entladeschlussspannung der Batteriezelle zugehöriger Ladezustand, SOC (121) erreicht ist, basierend auf einer analytischen Lösung einer Funktion (110), welche einen Zusammenhang zwischen der Ruhespannung und dem Ladezustand (121) der Batteriezelle angibt; und

Ermitteln (703) des Ladezustands (121) der Batteriezelle basierend auf einer Umkehrfunktion (120) der ladezustandsabhängigen Zeit (111).

100

U1, U2, ... Un, ← 101
t1   t2      tn  ← 102

....

110 — $f$

t(θ) ← 111

120 — F

SOC ← 121

Fig. 1

200

Fig. 2

300

Fig. 3

400

Fig. 4

500

501

502

Fig. 5

Fig. 6

700

701

Erhalten einer Mehrzahl von Messwerten einer Ruhespannung der Batteriezelle mit zugehörigen Zeitwerten, zu denen die Messwerte der Ruhespannung erfasst wurden

702

Bestimmen einer Zeit, bis zu der ein zu einer Entladeschlussspannung der Batteriezelle zugehöriger Ladezustand, SOC, erreicht ist, basierend auf einer analytischen Lösung einer Funktion, welche einen Zusammenhang zwischen der Ruhespannung und dem Ladezustand der Batteriezelle angibt

703

Ermitteln des Ladezustands der Batteriezelle basierend auf einer Umkehrfunktion der ladezustandsabhängigen Zeit

Fig. 7

Europäisches Patentamt

European Patent Office

Office européen des brevets

## EUROPÄISCHER RECHERCHENBERICHT

Nummer der Anmeldung

EP 23 21 4480

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DE 10 2021 110384 A1 (DRAEXLMAIER LISA GMBH [DE]) 27. Oktober 2022 (2022-10-27) * Abbildungen 1,7 * * Absatz [0002] * * Absatz [0024] * * Absatz [0054] * * Absatz [0062] * * Anspruch 4 * ----- | 1-17 | INV. G01R31/367 G01R31/374 G01R31/3835 |
| Y | US 2010/045240 A1 (BERGVELD HENDRIK JOHANNES [NL] ET AL) 25. Februar 2010 (2010-02-25) * Abbildung 2 * * Ansprüche 1-2,4 * * Absatz [0032] – Absatz [0033] * ----- | 1-17 | |
| Y | V. POP: "Accuracy analysis of the State-of-Charge and remaining run-time determination for lithium-ion batteries", MEASUREMENT., [Online] Bd. 42, Nr. 8, 1. April 2008 (2008-04-01), Seiten 1131-1138, XP093153230, GB ISSN: 0263-2241, DOI: 10.1016/j.measurement.2008.03.009 [gefunden am 2024-04-17] * Zusammenfassung * * Gleichung 4 oder 9 * * "3.1 Initial state" * * "5. New battery models to improve the prediction accuracy" * ----- | 1-17 | RECHERCHIERTE SACHGEBIETE (IPC) G01R |

−/−−

Der vorliegende Recherchenbericht wurde für alle Patentansprüche erstellt

| Recherchenort | Abschlußdatum der Recherche | Prüfer |
|---|---|---|
| Den Haag | 18. April 2024 | Rambaud, Patrick |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.........................................................................
& : Mitglied der gleichen Patentfamilie, übereinstimmendes Dokument

Seite 1 von 2

EUROPÄISCHER RECHERCHENBERICHT

Nummer der Anmeldung

EP 23 21 4480

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | QUAN-QING YU: "A Comparative Study on Open Circuit Voltage Models for Lithium-ion Batteries", CHINESE JOURNAL OF MECHANICAL ENGINEERING : THE OFFICIAL JOURNAL OF THE CHINESE MECHANICAL ENGINEERING SOCIETY, [Online] Bd. 31, Nr. 1, 17. August 2018 (2018-08-17), XP093152333, CN ISSN: 1000-9345, DOI: 10.1186/s10033-018-0268-8 Gefunden im Internet: URL:http://link.springer.com/article/10.1186/s10033-018-0268-8/fulltext.html> [gefunden am 2018-12-01] * Tabelle 2 * * "1 Introduction" * * "4.3 Sensitivity to Ambient Temperatures" * * "4.5 Impacts on SoC Estimation" * ----- | 2-8,14, 16 | |
| A | US 10 663 524 B2 (DENSO CORP [JP]) 26. Mai 2020 (2020-05-26) * Ansprüche 1,3 * ----- | 2-8 | RECHERCHIERTE SACHGEBIETE (IPC) |
| A | CN 108 508 371 A (UNIV CHONGQING) 7. September 2018 (2018-09-07) * Abbildungen 2-3 * ----- | 12,13 | |

Der vorliegende Recherchenbericht wurde für alle Patentansprüche erstellt

| Recherchenort | Abschlußdatum der Recherche | Prüfer |
|---|---|---|
| Den Haag | 18. April 2024 | Rambaud, Patrick |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
......................................................................
& : Mitglied der gleichen Patentfamilie, übereinstimmendes Dokument

EPO FORM 1503 03.82 (P04C03)

Seite 2 von 2

**ANHANG ZUM EUROPÄISCHEN RECHERCHENBERICHT
ÜBER DIE EUROPÄISCHE PATENTANMELDUNG NR.**

EP 23 21 4480

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-04-2024

| Im Recherchenbericht angeführtes Patentdokument | Datum der Veröffentlichung | Mitglied(er) der Patentfamilie | Datum der Veröffentlichung |
|---|---|---|---|
| DE 102021110384 A1 | 27-10-2022 | CN 115236527 A<br>DE 102021110384 A1 | 25-10-2022<br>27-10-2022 |
| US 2010045240 A1 | 25-02-2010 | JP 2010518390 A<br>US 2010045240 A1<br>WO 2008099298 A1 | 27-05-2010<br>25-02-2010<br>21-08-2008 |
| US 10663524 B2 | 26-05-2020 | JP 6455409 B2<br>JP 2016166857 A<br>US 2018045788 A1 | 23-01-2019<br>15-09-2016<br>15-02-2018 |
| CN 108508371 A | 07-09-2018 | KEINE | |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **SHAH, M.** On generalization of some results and their applications. *Collectanea Mathematica,* 1973, vol. 24 (3), 249-266